# EUROPEAN PATENT SPECIFICATION

(11) **EP 0 610 052 B1**
(45) Date of publication and mention of the grant of the patent: **02.01.2003**
(21) Application number: 94300709.6
(22) Date of filing: 31.01.1994
(51) Int. Cl.: H03L 7/093, H03L 7/099, H03L 7/081, H03K 5/15, H03K 5/13

(54) **Method and apparatus for timing control**
Verfahren und Gerät zur Taktsteuerung
Méthode et appareil pour la commande d'horloge

(30) Priority: 05.02.1993 US 14121
(43) Date of publication of application: 10.08.1994
(60) Divisional application: 01201022.9
(73) Proprietor: SUN MICROSYSTEMS, INC., Mountain View, CA 94303 (US)
(72) Inventor: Bassett, Paul D., Boxboro, Massachusetts 01719 (US)
(74) Representative: Harris, Ian Richard

(56) References cited:
- EP-A- 0 330 984
- US-A- 4 352 074
- US-A- 4 875 108
- US-A- 4 928 075
- US-A- 5 146 121
- MOTOROLA TECHNICAL DEVELOPMENTS, vol.13, July 1991, SCHAUMBURG, ILLINOIS US pages 11 - 13, XP000259086 S. R. MCCASLIN ET AL. 'Ring-Oscillator PLL Phase Selectors'
- PATENT ABSTRACTS OF JAPAN vol. 7, no. 182 (E-192) 11 August 1983 & JP-A-58 087 902 (MITSUBISHI DENKI KK) 25 May 1983

## Description

The present invention relates the coordination of timing of electronic sequential logic systems.

Computers and other digital systems are constructed from discrete logic devices, such as processing, memory, and interface devices. Overall operation of these systems depends on synchronous operation of the underlying logic devices. Typically, synchronism is attained by driving a common clock signal to the devices and strobing their respective input, output and processing operations based on that signal. In high-speed systems, e.g., supercomputers, extraordinary demands are placed on the circuitry provided with each individual logic device to synchronize its responses to the reference clock signal.

One particular problem is that of "clock skew," which results from differences in the propagation delays of buffer circuits within the logic devices. As those skilled in the art will appreciate, buffers are provided to reduce the capacitive load on the common, or external, reference clock signal. Clock signals applied to each device are delayed as they pass through the respective buffers. The length of the delay varies based on the specific characteristics of each buffer. Because those characteristics and the resulting delays tend to vary, it has generally proven difficult to ensure synchronous operation of complex, high-speed systems.

The art has proposed various timing control systems to compensate for propagation delay-induced clock skew. One such solution provides, within each discrete logic device, a phase lock loop that "locks" onto the external reference clock signal and generates an internal clock signal that is coordinated, in phase and frequency, to the external clock. Each device operates from its respective internal clock signal instead of the external clock, from which it is capacitively decoupled and, yet, coordinated in frequency and phase.

Although this solution is adequate for some systems, it is generally not suitable for digital processing systems that operate at more than one processing speed or in a noisy environments. In such circumstances, because a conventional phase lock loop is constrained by a limited "capture" range, it may not be able to lock onto the external clock and, therefore, will not be able to generate a synchronous internal clock signal.

In addition to clock skew, further timing control problems often arise when there are transient variations in power supply voltage levels. In this regard, it will be appreciate that the processing speed of many individual logic devices decreases as power supply voltage levels fall. Because these changes vary from device to device, momentary dips in power level (which dips can occur even in the normal course, e.g., when multiple devices simultaneously draw increased power) can disrupt the synchronous operation of multiple devices.

A further problem in timing control is the synchronization of signals (e.g., data) output by multiple logic devices. As above, the coordination of output signals depends on propagation delays of the circuitry used by those devices to buffer outgoing signals. Differences can result in signal skew between otherwise synchronous data output by the devices. This, in turn, can slow overall processing speed, as the system compensates by holding otherwise inactive data output by the faster devices.

US Patent US-A-4,928,075 describes a multiple bandwidth filter system for a phase locked loop. A method and apparatus is described for combining a plurality of different parts of varying bandwidth to provide selectable bandwidth signal filtering without transients caused by initialisation of filter components. The signal to be filtered is applied to a plurality of parallel connected passband filters ranging from a widest passband filter to a narrowest passband filter. The bandwidth of the parallel filter combination is progressively narrowed by sequentially holding the output level of each of the filters in declining order of their passband frequency range, beginning with the widest passband filter, until all of the output levels of the filter are held constant except for the narrowest passband filter. The filter system is especially adapted as a loop filter in a phase lock loop control system incorporated in a data storage disk drive.

US Patent US-A-4,928,075 thus describes a timing control apparatus for generating an output clock signal that is co-ordinated to an input clock signal. The timing control apparatus comprising a oscillator configured to generate the output clock signal. A comparator configured to receive the input clock signal and the output clock signal and to generate and error signal representative of a difference in phase and frequency between the input and output clock signals. A filter is configured to receive the error signal and to generate a plurality of control signals, each control signal having a voltage amplitude with a selected mathematical relationship to a respective portion of the frequency spectrum of the error signal. An aim of the present invention is to provide an improved timing control system, particularly adapted to the timing control environment described in the introduction.

In accordance with the present invention, there is provided timing control apparatus for generating an output clock signal that is coordinated to an input clock signal, comprising: an oscillator configured to generate said output clock signal; a comparator configured to receive said input clock signal and said output clock signal and to generate an error signal representative of a difference in phase and frequency between said input and output clock signals; and a filter configured to receive said error signal and to generate a plurality of control signals, each control signal having a voltage amplitude with a selected mathematical relationship to a respective portion of the frequency spectrum of said error signal; characterised in that: said oscillator comprises a plurality of ring oscillators, each ring oscillator receiving a signal derived from one of said plurality of control signals to generate said output clock signal to have a frequency and phase that is a function of a weighted sum of the voltage amplitude of said plural control signals, with a control signal representing higher frequency components being weighted less than a control signal representing lower frequency components.

Various embodiments of the invention may variously provide an improved timing control apparatus that operates over a wide range of processing speeds to coordinate the synchronous operation and multiple logic devices to a common external reference signal.

In an embodiment of the invention, the filter can be a third-order low-pass filter that generates one control signal as a function of a first portion of frequency spectrum, e.g., the fundamental frequency of possible external reference clocks, and tht generates another control signal as a function of a second portion of the frequency spectrum, e.g., the probable frequency bands of system noise.

An embodiment of the invention can provide a timing control apparatus that generates a plurality of time-delayed signals coordinated to an input signal, e.g., an external clock signal. The oscillator generates an internal clock reference signal and a delay element generates time-delayed signals offset from that internal clock signal. The comparator compares the internal and external clock signals to generate an error signal that indicates the phase and frequency difference therebetween. The filter, coupled to the comparator, generates the plurality of control signals that each have a voltage amplitude that is a selected function of the error signal. Those control signals are fed to the oscillator which, in turn, feeds output to the delay element. The delay element, which can employ a ring of CMOS inverter gates, generates the time-delayed signals, each with a frequency substantially equal to that of the output signal and with a selected time-delay with respect thereto.

Embodiments of these and other aspects of the present invention will now be described, by way of example only, with reference to the accompanying drawings, of which:
FIGURE 1 is a schematic representation of a preferred timing control apparatus according to the invention for generating an internal clock signal coordinated to an external reference clock signal.
FIGURE 2 is a detailed schematic representation of the device of FIGURE 1.
FIGURE 3 is a detailed schematic representation of a preferred voltage controlled oscillator used in the apparatus of FIGURE 1.
FIGURE 4 is a schematic representation of a preferred timing control apparatus as shown in Figure 1 including circuitry for generating time-delayed signals coordinated to an input signal.
FIGURE 5 is a detailed schematic representation of the delay circuit of FIGURE 4.
FIGURE 6 is a schematic representation of preferred timing control apparatus including a device-dependent delay feature, e.g., for synchronizing the generation of output signals.
FIGURE 7 is a detailed schematic representation of a preferred process dependent delay 300 of Figure 6.
Figure 8 illustrates a sequential phase detector for use with comparator 20 (Figure 1) of a preferred timing control apparatus according to the invention.

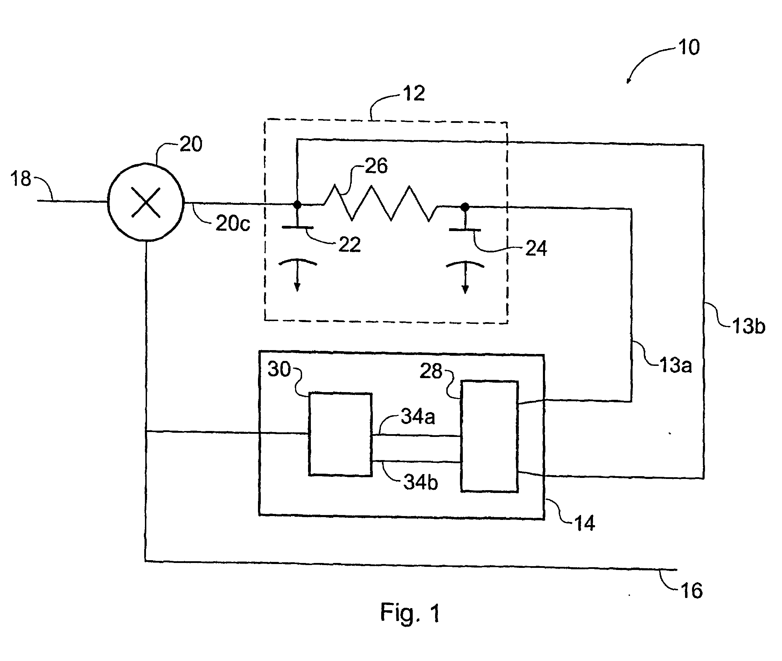

Figure 1 depicts a preferred timing control apparatus 10 constructed according to the invention for synchronizing the operation of an associated logic device, e.g., an integrated circuit chip or board (not shown), to an external clock signal 18. The apparatus 10 is generally configured as a feedback system and, more particularly, as a phase locked loop (PLL) with a filter 12 that generates multiple control signals 13a, 13b for controlling generation of an internal reference clock signal 16 by a voltage controlled oscillator (VCO) 14.

Referring to the drawing, the apparatus 10 includes a comparator 20 that generates an error signal 20c representing the difference in phase and frequency between the internal reference clock signal 16 and the external clock signal 18. The filter 12 is coupled to the comparator 20 to generate the control signals 13a, 13b, each having a voltage amplitude that is a function of the error signal 20c. Those control signals, which are preferably generated based on characteristics of respective selected frequency spectra of the error signal, are routed to VCO 14 for adjustment of the internal reference clock signal 16 as described below.

The external reference clock signal 18 can be, for example, a computer system clock or other control signal intended for synchronizing the operation of a sequential logic system. The external reference clock used in connection with a preferred embodiment of the invention operates in the range of 20 to 50 MHz and, preferably, 40 MHz. The internal reference clock signal 16 can, for example, serve as an internal clock signal for controlling operation of the associated logic device.

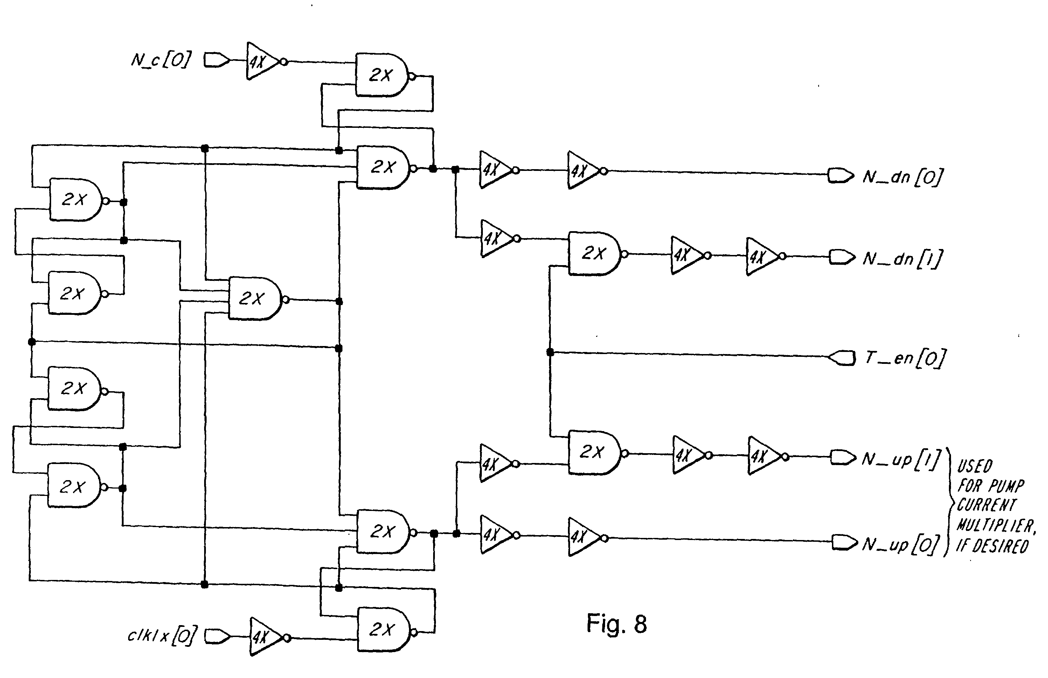

The comparator 20 can be constructed and operated in accord with conventional phase comparator structures, for example, an analog multiplier circuit or a digital EXCLUSIVE OR gate. A preferred such structure is a sequential phase detector (commonly referred to as a "phase-frequency detector"), of the type well known in the art. A preferred such structure is shown in Figure 8.

The filter 12 is a multiple response filter having subelements that generate respective unique control signals 13a, 13b in response to the error signal 20c. Preferably, those subelements generate those respective signals in response to selected respective portions of the frequency spectrum of the error signal 20c. The preferred, illustrated filter 12 is a third order low-pass filter comprising large capacitor 22, small capacitor 24 and resistor 26, arranged as shown.

As illustrated, control signal 13b is generated at the anode of the capacitor 22, while control signal 13a is generated at the anode of the capacitor 24. It will be appreciated that, in accord with the illustrated structure, control signals 13a, 13b are generated in response to substantially different frequency bands of the error signal. These different frequency bands can be selected by selecting or adjusting the values of the capacitors 22 and 24 and resistor 26 in accord with the teachings herein.

By way of example, in a preferred embodiment for use in synchronizing an external reference clock (as above, operating in the range of 20 to 50 MHz and, preferably, 40 MHz), capacitor 22 has a value of 2.5 pF , capacitor 24 has a value of 25 pF and resistor 26 has a value of 1k Ohms. In that embodiment, control signal 13a has a frequency band of 0 - 10 MHz, while control signal 13b has a frequency band of 0 - 16 MHz.

It will be appreciated that, in lieu of the illustrated structure, filter 12 can include a plurality of separate filter circuits each with a unique transfer function.

The oscillator 14 is a voltage-controlled oscillator that has plural control inputs as illustrated. The oscillator 14 includes an interface 28 that responds to the control signals 13a, 13b to generate frequency control signal 34a, 34b that toggle switch 30. More particularly, the interface 28 is configured to adjust the frequency of the switch 30 to reduce the difference between the frequency and the phase of the external clock signal 18 and the internal clock signal 16 in the manner described below. As illustrated, the signal 16 generated at the output of oscillator 14 is routed to comparator 20, as well as to the associated logic device for use in the timing and control thereof.

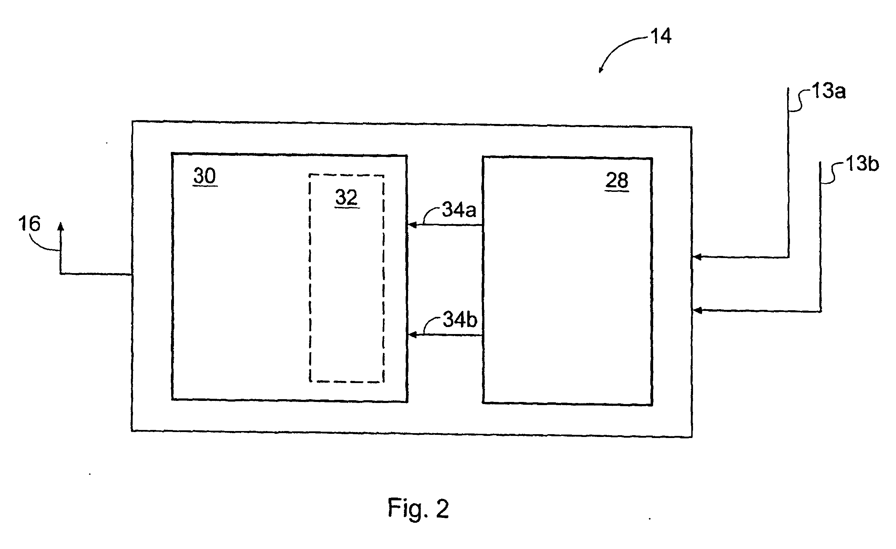

Figure 2 illustrates a preferred structure of voltage controlled oscillator 14. The voltage controlled oscillator 14 includes interface 28 configured as a voltage-controlled current source coupling control signals 13a, 13b, to the switch circuit 30. The switch circuit 30 can include a weighted sum network 32, connected to the voltage-controlled current source 28, that weights each frequency control signal 34a, 34b so that each has a selected effect on the rate at which the circuit switch 30 toggles and, consequently, on the frequency of the internal reference clock signal 16.

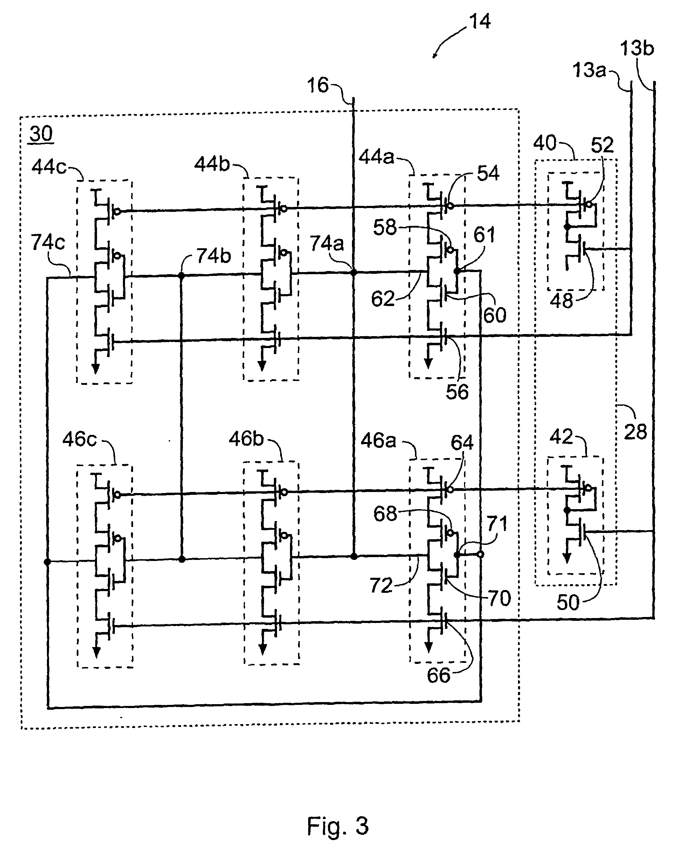

Figure 3 illustrates in still greater detail the structure of the voltage controlled oscillator 14. There it is seen that interface 28 consists of two voltage-controlled current sources, 40, 42, each responsive to a respective control signal 13a, 13b. The switch circuit 30, in turn, includes three pairs of ring oscillators stages, 44a/46a, 44b/46b, and 44c/46c.

More particularly, as shown in the drawing, the switch is constructed from three identical stages which are, in turn, constructed from identically configured sub-stages wired in parallel. Each sub-stage is connected to one of the current sources 40, 42 and is therefore responsive to one of the control signals 13a, 13b. In the example shown, substages 44a, 44b and 44c are connected to the current source 40 and are responsive to control signal 13a, while substages 46a, 46b and 46c are connected to current source 42 and are responsive to control signal 13b. It will be appreciated that further current sources and substages of the type illustrated could be added to the switch 30 to accommodate additional control signals generated by filter 12. It will also be appreciated that while switch 30 is shown to include three stages, the oscillator could be constructed from any odd number of stages (though, not necessarily from a single stage).

Illustrated current sources 40 and 42 each have an NMOS device with its gate connected to a corresponding input terminal of the oscillator 14, and with its source connected to the source of a matched PMOS device configured in saturation mode. In the illustrated embodiment, more particularly, exemplary current source 40 has an NMOS device 48 with a gate connected to an input terminal coupled to control signal 13a, while the current source 42 has an NMOS device 50 connected to terminal coupled to control signal 13b.

The structure and operation of current sources 40, 42 will now be described with reference to exemplary current source 40.

Control signal 13a from filter 12 is routed to the gate of the NMOS device 48 to regulate the current through both it (the NMOS device 48) and the associated PMOS device 52. In operation, the control signal 13a places a voltage bias across the gate-to-source junction of the NMOS device 48 and draws a proportional reference current through both the NMOS device 48 and PMOS device 52. The reference current drawn through the PMOS device 52 causes a voltage drop occurs across the gate-to-drain junction of the PMOS device 52 identical to the voltage drop across the gate-to-drain junction of the NMOS device 48. In this way, the current source 40 produces two control voltages at the gates of MOS devices 48, 52 proportional to the reference current drawn through those devices 48, 52 and, therefore, proportional to the control signal 13a.

The ring oscillator 44 couples to both MOS devices 48, 52 as illustrated.

As further illustrated, the gate of the PMOS device 52 connects to the gate of the PMOS device 54, each, while the gate of the NMOS device 48 connects to the gate of the NMOS device 56. This structure causes the devices 54 and 56 to act as current mirrors to the current source 40. Accordingly, current driven through the inverter circuit 44 is proportional to the control signal 13a received at input terminal 14a.

With continued reference to Figure 3, a second pair of MOS devices, 58 and 60 form a CMOS inverter gate that switches between current mirrors 54 and 56 to drive the output 62. The load on each delay stage within the circuit 30 is equal to the load presented by the next pair of substages and is fixed. With this structure, and the fixed output load, the output voltage at 62 switches at a speed that is dependent on the current driven by the current mirrors 54 and 56. Therefore, the rate at which the ring oscillator 44a toggles is controlled by the voltage level of the control signal 13a.

The outputs of ring oscillators 44a, 46a are wired together to form the outputs of the switch circuit 30. Illustrated output 74a is a summing node that sums the output currents of ring oscillators 44a and 46a, as shown. Similarly, the outputs of sub-stages 44b, 46b are connected to form 74b, while the outputs of sub-stages 44c and 46c are connected to form 74c. The output 74c is fed-back to the inputs 61 and 71 of each sub-stage 44a and 46a, as shown. As a result of this feedback structure, the switch circuit 30 forms an oscillator. The rate at which the switch circuit 30 oscillates depends on the rate at which each of the stages toggles and this, in turn, depends on the currents driven by the current mirrors within the sub-stage circuits.

The optional weighting network 32, referred to above (in connection with the discussion of Figure 2), is implemented by constructing the ring oscillators 44a and 46a with MOS devices of different sizes. Specifically, those devices are selected to produce a desired mirror current for a specific bias voltage at the gate of the current mirror devices 54 , 56, 64 and 66.

In one preferred embodiment, the n-type MOS devices of the ring sub-stage 44a are 35 microns wide and the n-type MOS device of sub-stage 46a are 20 microns wide. This relative sizing causes the switch circuit 30 to weight the control signal 13a 7/4 (seven-fourths) times as much as the control signal 13b. The sum total of the output current at output 74a is therefore four times the current generated by the current source, 42, connected to control signal 13b and seven times the current generated by the current source, 40, connected to control signal 13a

It will be appreciated that the structures described above enable the oscillator 14 to be more responsive to those portions of the frequency spectrum of the error signal 20c that are most instrumental in synchronizing the frequency and phase of the reference clocks. Thus, high frequency noise components of the error signal 20c are transmitted from the low pass filter 12 as one control signal. The oscillator summing network 32 assigns a minimal weight to this control signal. Accordingly, small variations in the phase of the external clock signal 18 due to noise have less effect on the final generated internal reference clock 16 than does the fundamental frequency component of the external reference clock signal 18. As a result, the generated reference clock signal 16 is less affected by noise-induced transient frequency variations.

In sum, the timing control device 10, described above, synchronizes an internal reference clock signal 16 to an external reference clock 18. The device uses selected portions of the frequency spectrum of the error signal to control the generation of the internal reference clock 16. This enables the oscillator 14 to have a high voltage-to-frequency gain for certain frequency bands (and, therefore, to have a fast transient response within these bands) and, yet, still have a stable response to a broad range of frequencies. It will be appreciated that this new structure is both highly responsive and highly stable.

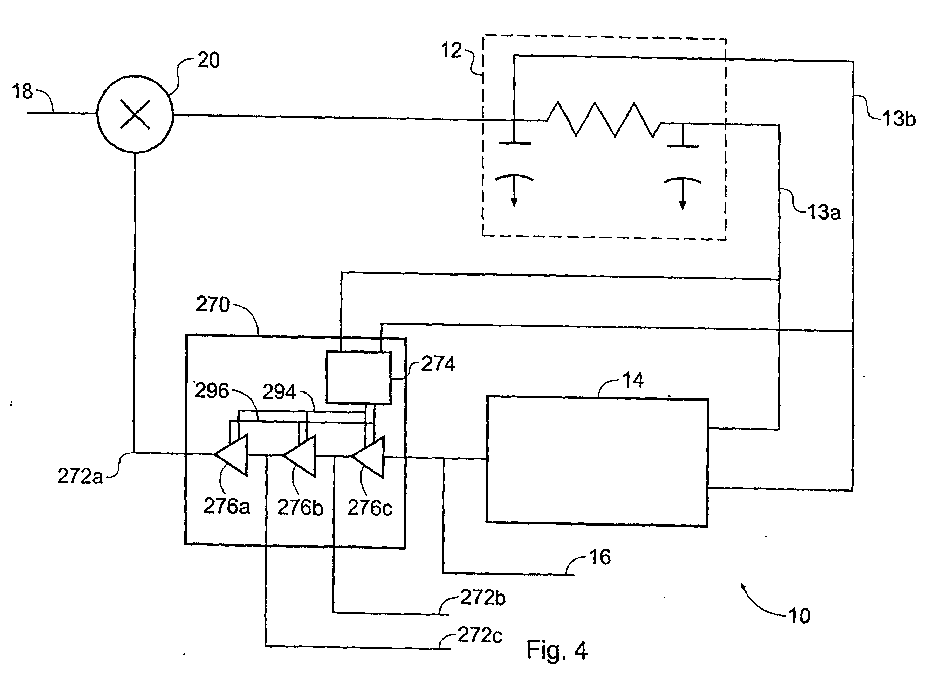

Referring now to Figure 4, there is shown a preferred timing control apparatus for generating a plurality of time-delayed signals coordinated to an input signal.. The apparatus includes a delay element 270 for generating the time-delayed signals, designated 272a, 272b, 272c, and a comparator 20 for generating an error signal that represents a difference in phase and frequency between the input signal and at least one of the time-delayed signals, 272a. A filter 12, coupled to the comparator 20, generates plural control signals 13a, 13b each having a voltage amplitude that is a selected function of the error signal. An oscillator 14 receives the control signals 13a, 13b and generates an internal reference clock signal 16 having a frequency and phase that is a function of these control signals. Comparator 20, filter 12 and oscillator 14 preferably operate in accord with the like-designated elements described above.

The internal reference clock signal 16 is fed-back to the delay element 270, as indicated, which generates the time-delayed signals 272a, 272b, 272c, each with a frequency substantially equal to that of the clock signal 16, but with a selected time-delay with respect thereto. For this purpose, element 270 can employ plurality of CMOS inverter gates, each driving a respective one of the time-delayed signals, as described below.

It will be appreciated that the position of the delay device 270 within the feed-back loop of the device 10 inserts a selected time delay, and therefore a corresponding phase delay, into the internal clock signal 16. The phase comparator 20 therefore compares a delayed version of the internal reference clock signal 16 to the external reference clock signal 18. As a result, the internal reference clock signal 16 leads the external reference clock signal 18 by the phase delay inserted by the delay device 270. This enables the timing control device 10 to advance the internal timing of a sequential logic device by the selected phase lead, and, consequently, to compensate for known constant time delays within the logic device.

The delay device 270 includes a plurality of delay circuits 276a, 276b, 276c wired in series between the oscillator 14 and the phase comparator 20, and an interface 274. The interface 274 is configured as shown to respond to control signals 13a, 13b to generate delay select signals 294, 296 which are driven to delay circuits 276a, 276b, 276c, as shown. Interface 274 is a voltage controlled current source, preferably, like that described above in connection with element 28 (of Figure 2).

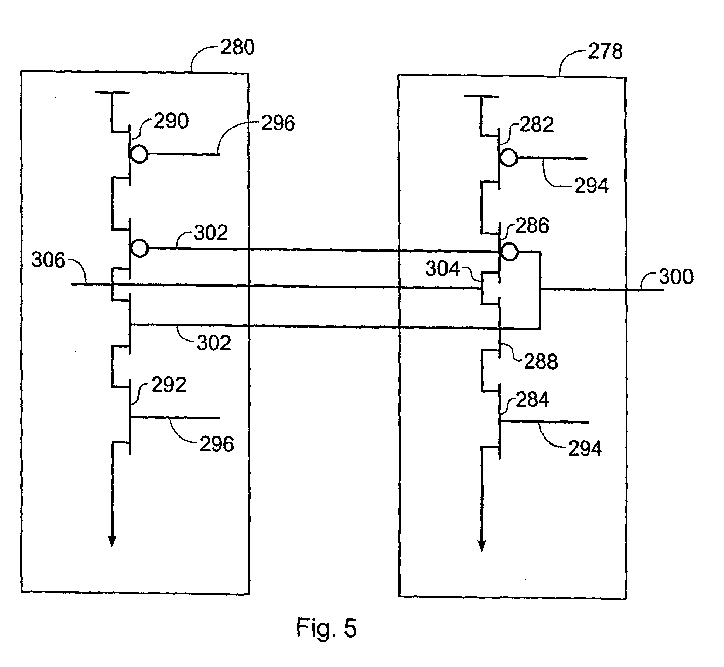

Figure 5 illustrates in detail a preferred embodiment of the delay circuit. There, the circuit is shown to include two stages 278 and 280 wired in parallel. The first stage 278 connects to the second stage 280 so that the input 300 (of stage 278) connects to the input 302 (of stage 280), and so that the output 304 (of stage 278) connects to the output 306 (of stage 280). The two stages 278 and 280 are connected to separate delay select signals and, therefore, are independently controlled.

Stage 278 has two MOS device 282 and 284 that connect to the delay select signals 294. The MOS devices 282 and 284 are configured as current mirrors responsive to the control signals 294 generated by the interface 274. The current mirrors 282 and 284 drive a current through the stage 278 responsive to a selected one of the control signals 13.

The current mirrors 282 and 284 connect to a second pair of MOS devices 286 and 288 that are configured as a CMOS inverter gate. The CMOS inverter gate connects to the input 300 and receives the clock signal propagating through the delay device 270. The CMOS inverter is configured to switch on a current mirror responsive to the signal level applied at the input 300. In response to a high signal on the input 300, the NMOS device 288 is activated and the current source 284 drives the output 304.

The load on the current mirror 284 is fixed. With this structure, and the fixed output load, the output voltage at 304 switches at a speed that is dependent on the current driven by the current mirror 284. Therefore, the delay through the stage 278 is adjusted according to the delay select signal 294.

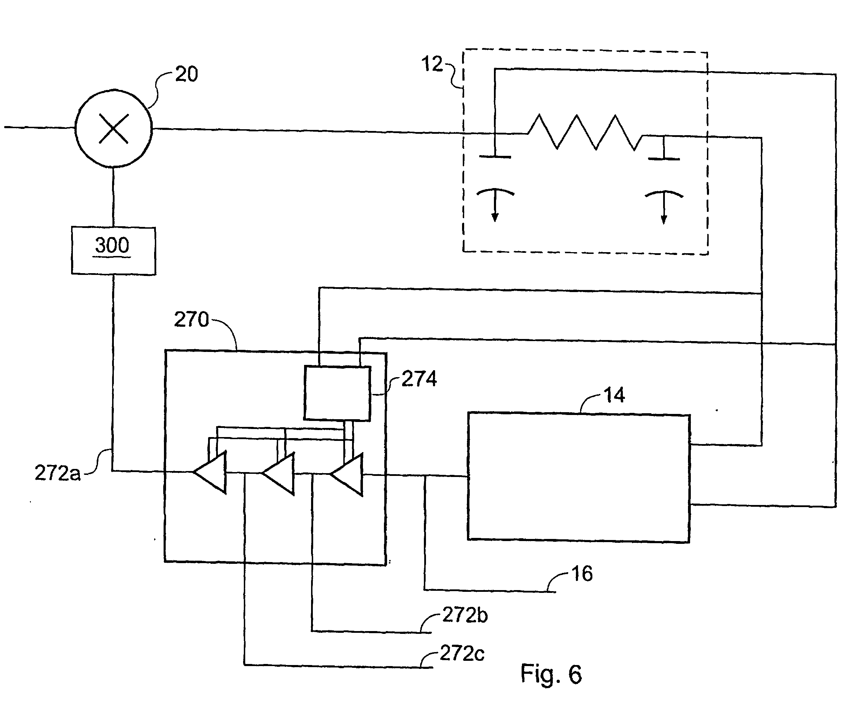

Figure 6 illustrates a preferred embodiment of the invention that further includes a device dependent delay 300, coupled between the oscillator 14 and the comparator 20, to effect delay in the generation of internal clock signal 16 based on the propagation delay of an output buffer of the associated logical device.

Preferably, delay 300 includes a buffer circuit of identical construction to that utilized to drive the output data signals from the logic device. As a result, element 300 suitably delays the internal reference clock 16 before comparison to the external reference clock 18. Accordingly, the oscillator 14 generates a clock signal 16 that leads the external clock signal 18 by a period of time equal to the propagation delay of the output buffer circuits. It will be appreciated that this compensates for the propagation delay of data signals through output buffer circuits and eliminates the signal skew between the individual portions of data output by multiple devices.

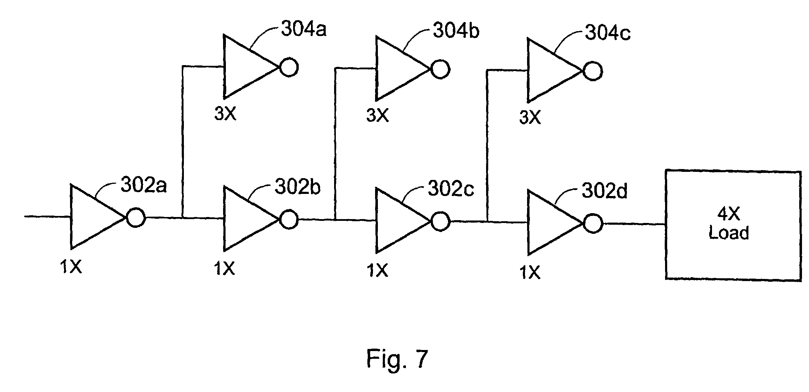

Figure 7 illustrates in greater detail the construction of one embodiment of a process dependent delay 300. The purpose of the element 300 is to match any delay introduced when signals are routed between circuit elements, to wit, IC chips. Those skilled in the art will appreciate that the inter-chip delay has two components:
1) Buffering delay. The relatively weak devices inside a chip are generally not able to drive large external loads directly. Producing a signal with sufficient strength typically requires 2 - 4 stages of buffering. The delay introduced by each stage is proportional to the ratio between the sizes of the stage and the load it is driving. This ratio is referred to as the "fanout." For a given process, any two buffers that have the same fanout will produce the same delay.
2) Process delay. Due to variations in the manufacturing process, the chip-to-chip difference in delay for a given fanout can a large amount, typically 200 - 300%.

Those skilled in the art will further appreciate that an addition difficulty makes it difficult to produce a usable on-chip delay which matches the output buffer delay. The difficulty is that on-chip loads are so small that driving them with a 64X buffer produces fanout and process delay well below that "seen" by the last stage of the output buffer.

Figure 7 depicts a preferred delay element 300 capable of compensating for the aforementioned delays and difficulties. The element 300 includes a plurality of equally-sized 1X buffers 302a - 302d connected in series, as shown. An additional "sacrificial" 3X load is added to the output of each 1X buffer. Thus, load 304a is added to the output of buffer 302a, load 304b to buffer 302c, and load 304c to buffer 302d, as shown. This structure produces a fanout of 4X at each stage without requiring an additional load at each stage.

An embodiment of the invention can attain a highly accurate timing control device for synchronizing and coordinating a sequential logic device to an external reference clock, and for synchronizing and coordinating the operation of multiple logic devices to an external reference clock signal, so that the timing variations inherent in synchronous computer systems are compensated for within an automatic, closed-loop control system.

Further, an embodiment of the invention as described in the foregoing can be manufactured as a silicon component carried on the wafer of the logic device. This is desirable to reduce the size and density of computer systems and to facilitate and reduce the cost of system manufacture and assembly.

## Claims

1. Timing control apparatus for generating an output clock signal (16) that is coordinated to an input clock signal (18), comprising:
an oscillator (14) configured to generate said output clock signal;
a comparator (20) configured to receive said input clock signal and said output clock signal and to generate an error signal (20c) representative of a difference in phase and frequency between said input and output clock signals; and
a filter (12) configured to receive said error signal and to generate a plurality of control signals (13a,13b), each control signal having a voltage amplitude with a selected mathematical relationship to a respective portion of the frequency spectrum of said error signal;
**characterised in that**:
said oscillator (14) comprises a plurality of ring oscillators (44a-c, 46a-c), each ring oscillator receiving a signal derived from one of said plurality of control signals (13a, 13b) so as to generate said output clock signal to have a frequency and phase that is a function of a weighted sum of the voltage amplitude of said plural control signals, with a control signal representing higher frequency components being weighted less than a control signal representing lower frequency components.

2. Timing control apparatus according to Claim 1, wherein said oscillator comprises a plurality of voltage controlled current sources (40,42), each responsive to a respective control signal.

3. Timing control apparatus according to Claim 2, wherein each ring oscillator (44a-c, 46a-c) receives the output of a respective voltage controlled current source (40, 42), said ring oscillators being configured respectively to provide said weighting for generating said output clock signal with a frequency and phase that are a function of a weighted sum of the voltage amplitude of said plurality of control signals( 13a, 13b).

4. Timing control apparatus according to Claim 3, wherein said oscillator (14) is configured to generate said output clock signal with a frequency and phase that is substantially a function of four times the current of a first current source (42) and seven times the current of a second current source (40).

5. Timing control apparatus according to any preceding claim, wherein said filter (12) comprises a plurality of subfilters (22, 24, 26), each responsive to said error signal and configured to generate a respective one of said unique control signals (13a, 13b) according to a respective selectable transfer characteristic.

6. Timing control apparatus according to claim 5, wherein said subfilter (22, 24, 26) is configured to generate at least one of said control signals (13a, 13b) based on a characteristic of a selected portion of the frequency spectrum of said error signal (20c).

7. Timing control apparatus according to any one of claims 1 to 4, wherein said filter (12) comprises a low-pass filter having at least two outputs (13a, 13b) each of which generates a respective one of said control signals as a function of a respective portion of the frequency spectrum of said error signal (20c).

8. Timing control apparatus according to claim 7, wherein said low-pass filter (12) is configured to generate at least one control signal as a function of a first portion of the frequency spectrum of said error signal (20c) and at least one other control signal has a function of a second portion of the frequency spectrum of said error signal (20c).

9. Timing control apparatus according to any preceding claim, wherein said respective portions of the frequency spectrum of said error signal overlap.

10. Timing control apparatus according to claim 9, wherein a first portion of the frequency spectrum of said error signal is 0-10MHz and a second portion of the frequency spectrum of said error signal is 0-16MHz.

## Patentansprüche

1. Taktsteuergerät für das Erzeugen eines Ausgangstaktsignals (16), das mit einem Eingangstaktsignal (18) abgestimmt ist, das aufweist:
einen Oszillator (14), der derart konfiguriert ist, daß er das Ausgangstaktsignal erzeugt,
einen Vergleicher (20), der derart konfiguriert ist, daß er das Eingangstaktsignal und das Ausgangstaktsignal empfängt und daß er ein Fehlersignal (20c) erzeugt, das eine Differenz in der Phase und der Frequenz zwischen dem Eingangs- und dem Ausgangstaktsignal darstellt, und
einen Filter (12), der derart konfiguriert ist, daß er das Fehlersignal empfängt und daß er eine Mehrzahl von Steuersignalen (13a, 13b) erzeugt, wobei jedes Steuersignal eine Spannungsamplitude mit einer ausgewählten mathematischen Beziehung zu einem entsprechenden Abschnitt des Frequenzspektrums des Fehlersignals hat,
**dadurch gekennzeichnet, daß**:
der Oszillator (14) eine Mehrzahl von Ringoszillatoren (44a-c, 46a-c) aufweist, wobei jeder Ringoszillator ein Signal empfängt, das von einem der Mehrzahl von Steuersignalen (13a, 13b) abgeleitet wird, so daß das Ausgangstaktsignal derart erzeugt wird, daß es eine Frequenz und eine Phase hat, die eine Funktion einer gewichteten Summe der Spannungsamplitude der Mehrzahl von Steuersignalen ist, wobei ein Steuersignal, das höhere Frequenzkomponenten darstellt, geringer gewichtet ist als ein Steuersignal, das niederfrequente Komponenten darstellt.

2. Taktsteuergerät nach Anspruch 1, wobei der Oszillator eine Mehrzahl von spannungsgesteuerten Stromquellen (40, 42) aufweist, die jeweils auf ein entsprechendes Steuersignal reagieren.

3. Taktsteuergerät nach Anspruch 2, wobei jeder Ringoszillator (44a-c, 46a-c) den Ausgangswert einer entsprechenden spannungsgesteuerten Stromquelle (40, 42) empfängt, wobei die Ringoszillatoren derart konfiguriert sind, daß sie die Wichtung für das Erzeugen des Ausgangstaktsignals mit einer Frequenz und einer Phase, die eine Funktion einer gewichteten Summe der Spannungsamplitude der Mehrzahl von Steuersignalen (13a, 13b) zur Verfügung stellen.

4. Taktsteuergerät nach Anspruch 3, wobei der Oszillator (14) derart konfiguriert ist, daß er das Ausgangstaktsignal mit einer Frequenz und einer Phase erzeugt, die im wesentlichen eine Funktion von viermal dem Strom einer ersten Stromquelle (42) und siebenmal dem Strom einer zweiten Stromquelle (40) ist.

5. Taktsteuergerät nach einem der vorherigen Ansprüche, wobei der Filter (12) eine Mehrzahl von Unterfiltern (22, 24, 26) beinhaltet, die jeweils auf das Fehlersignal reagieren und derart konfiguriert sind, daß sie ein entsprechendes der einzigartigen Steuersignale (13a, 13b) entsprechend einer jeweiligen auswählbaren Übertragungscharakteristik erzeugen.

6. Taktsteuergerät nach Anspruch 5, wobei der Unterfilter (22, 24, 26) derart konfiguriert ist, daß er zumindest eines der besagten Steuersignale (13a, 13b) erzeugt basierend auf einer Charakteristik eines ausgewählten Abschnittes des Frequenzspektrums des Fehlersignals (20c).

7. Taktsteuergerät nach einem der Ansprüche 1 bis 4, wobei der Filter (12) einen Tiefpaßfilter mit zumindest zwei Ausgängen (13a, 13b) aufweist, wobei jeder von diesen ein jeweiliges der Steuersignale erzeugt als eine Funktion eines jeweiligen Abschnittes des Frequenzspektrums des Fehlersignals (20c).

8. Taktsteuergerät nach Anspruch 7, wobei der Tiefpaßfilter (12) derart konfiguriert ist, daß er zumindest ein Steuersignal als eine Funktion eines ersten Abschnittes des Frequenzspektrums des Fehlersignals (20c) erzeugt und zumindest ein anderes Steuersignal eine Funktion eines zweiten Abschnitts des Frequenzspektrums des Fehlersignals (20c) hat.

9. Taktsteuergerät nach einem der vorherigen Ansprüche, wobei die jeweiligen Abschnitte des Frequenzspektrums des Fehlersignals sich überlappen.

10. Taktsteuergerät nach Anspruch 9, wobei ein erster Abschnitt des Frequenzspektrums des Fehlersignals 0 bis 10 MHz ist und ein zweiter Abschnitt des Frequenzspektrums des Fehlersignals 0 bis 16 MHz ist.

## Revendications

1. Appareil de commande d'horloge pour générer un signal d'horloge de sortie (16) qui est coordonné avec un signal d'horloge d'entrée (18), comprenant :
un oscillateur (14) configuré pour générer ledit signal d'horloge de sortie ;
un comparateur (20) configuré pour recevoir ledit signal d'horloge d'entrée et ledit signal d'horloge de sortie et pour générer un signal d'erreur (20c) représentatif d'une différence de phase et de fréquence entre lesdits signaux d'horloge d'entrée et de sortie ; et
un filtre (12) configuré pour recevoir ledit signal d'erreur et pour générer une pluralité de signaux de commande (13a, 13b), chaque signal de commande ayant une amplitude de tension avec une relation mathématique sélectionnée à une partie respective du spectre de fréquence dudit signal d'erreur ;
**caractérisé en ce que** :
ledit oscillateur (14) comprend une pluralité d'oscillateurs en anneau (44a-c, 46a-c), chaque oscillateur en anneau recevant un signal obtenu à partir d'un signal de ladite pluralité de signaux de commande (13a, 13b) de façon à générer ledit signal d'horloge de sortie pour avoir une fréquence et une phase qui sont fonction d'une somme pondérée de l'amplitude de tension desdits multiples signaux de commande, un signal de commande représentant les composantes de fréquence plus élevées étant moins pondéré qu'un signal de commande représentant les composantes de fréquence plus basses.

2. Appareil de commande d'horloge selon la revendication 1, dans lequel ledit oscillateur comprend une pluralité de sources de courant commandées en tension (40, 42), chacune sensible à un signal de commande respectif.

3. Appareil de commande d'horloge selon la revendication 2, dans lequel chaque oscillateur en anneau (44a-c, 46a-c) reçoit la sortie d'une source de courant commandée en tension respective (40, 42), lesdits oscillateurs en anneau étant configurés respectivement pour délivrer ladite pondération pour générer ledit signal d'horloge de sortie avec une fréquence et une phase qui sont fonction d'une somme pondérée de l'amplitude de tension de ladite pluralité de signaux de commande (13a, 13b).

4. Appareil de commande d'horloge selon la revendication 3, dans lequel ledit oscillateur (14) est configuré pour générer ledit signal d'horloge de sortie avec une fréquence et une phase qui sont sensiblement fonction de quatre fois le courant d'une première source de courant (42) et de sept fois le courant d'une seconde source de courant (40).

5. Appareil de commande d'horloge selon l'une quelconque des revendications précédentes, dans lequel ledit filtre (12) comprend une pluralité de sous-filtres (22, 24, 26), chacun sensible audit signal d'erreur et configuré pour générer un signal respectif desdits signaux de commande uniques (13a, 13b) en conformité avec une caractéristique de transfert sélectionnable respective.

6. Appareil de commande d'horloge selon la revendication 5, dans lequel ledit sous-filtre (22, 24, 26) est configuré pour générer au moins un desdits signaux de commande (13a, 13b) sur la base d'une caractéristique d'une partie sélectionnée du spectre de fréquence dudit signal d'erreur (20c).

7. Appareil de commande d'horloge selon l'une quelconque des revendications 1 à 4, dans lequel ledit filtre (12) comprend un filtre passe-bas ayant au moins deux sorties (13a, 13b), dont chacune génère un signal respectif desdits signaux de commande comme fonction d'une partie respective du spectre de fréquence dudit signal d'erreur (20c).

8. Appareil de commande d'horloge selon la revendication 7, dans lequel ledit filtre passe-bas (12) est configuré pour générer au moins un signal de commande comme fonction d'une première partie du spectre de fréquence dudit signal d'erreur (20c) et au moins un autre signal de commande comme fonction d'une seconde partie du spectre de fréquence dudit signal d'erreur (20c).

9. Appareil de commande d'horloge selon l'une quelconque des revendications précédentes, dans lequel lesdites parties respectives du spectre de fréquence dudit signal d'erreur se chevauchent.

10. Appareil de commande d'horloge selon la revendication 9, dans lequel une première partie du spectre de fréquence dudit signal d'erreur est de 0 à 10 MHz et une seconde partie du spectre de fréquence dudit signal d'erreur est de 0 à 16 MHz.
